# EUROPÄISCHE PATENTSCHRIFT

(11) **EP 2 501 214 B1**
(45) Veröffentlichungstag und Bekanntmachung des Hinweises auf die Patenterteilung: **22.05.2019**
(21) Anmeldenummer: 12159822.1
(22) Anmeldetag: 16.03.2012
(51) Int. Cl.: H05K 7/20

(54) **KLIMAANLAGE UND VERFAHREN ZUM KLIMATISIEREN EINES RAUMS**
Air conditioning device and method for air conditioning a room
Climatisation et procédé destiné à la climatisation d'une pièce

(30) Priorität: 16.03.2011 DE 202011000591 U
(43) Veröffentlichungstag der Anmeldung: 19.09.2012
(73) Patentinhaber: Weiss Klimatechnik GmbH, 35447 Reiskirchen-Lindenstruth (DE)
(72) Erfinder:
(74) Vertreter: Stoffregen, Hans-Herbert

(56) Entgegenhaltungen:
- DE-U1-202009 013 664
- DE-U1-202009 014 942

## Beschreibung

Die Erfindung bezieht sich auf eine Klimaanlage gemäß Anspruch 1, und auch auf ein Verfahren gemäß Anspruch 7.

Eine entsprechende Klimaanlage ist der DE 10 2009 030 114 A1 (= DE 20 2009 014 942 U1) zu entnehmen. Dabei befindet sich in dem zweiten Raum oder unmittelbar unter diesem in dem von dem Doppelboden begrenzten Hohlraum zumindest eine Ventilatoreinrichtung, über die aus dem ersten Raum Warmluft durch den Wärmetauscher hindurch angesaugt wird, um sodann klimatisierte, also gekühlte Luft über den Doppelboden den Kaltgängen zuzuführen.

Bei dieser Konstruktion, bei der der Doppelboden durch Trennbereiche unterteilt ist, die quer zu den Kaltgängen verlaufen, wird die Leistung der in dem Doppelboden angeordneten mehrere Ventilatoren umfassende Ventilatoreinrichtung auf die Kühlleistung auf den jeweiligen Kaltgang ausgelegt, der die größte Wärmelast aufweist. Hierdurch ist ein energetisch optimales Kühlen des ersten Raums nicht zwingend sichergestellt. Erfolgt eine Abstimmung auf den entsprechenden Kaltgang nicht, so besteht das Risiko, dass die erforderliche Kühlung einzelner Kaltgänge nicht erfolgt. Es besteht auch die Möglichkeit, dass die Ventilatoren entweder in dem zweiten Raum selbst oder mit ihren Saugöffnungen in diesem münden, so dass der zweite Raum flächenmäßig relativ groß sein muss.

Soll mit einer entsprechenden Klimaanlage ein bereits vorhandener Raum mit Doppelboden gekühlt werden, so kann dann, wenn die Höhe des Doppelbodens und damit der Querschnitt des Hohlraums relativ gering ist, der Nachteil auftreten, dass zum Zuführen der erforderlichen gekühlten bzw. klimatisierten Luft in die einzelnen Kaltgänge in dem Hohlraum ein dynamischer Druck mit der Folge aufgebaut ist, dass die von der Druckseite der Ventilatoreinrichtung am entferntesten liegenden Kaltgänge nicht im erforderlichen Umfang mit gekühlter Luft versorgt werden können; denn eine gleichmäßige Verteilung über sämtliche den Kaltgängen zugeordneten Durchbrechungen im Doppelboden kann grundsätzlich nur dann erfolgen, wenn ein statischer Druck im Hohlraum herrscht.

Eine Klimaeinrichtung, die in einem Zwischenboden angeordnet ist, der mit einem über diesem befindlichen Raum über Schlitze verbunden ist, ist der US-A-5 910 045 zu entnehmen.

Konditionierte Luft wird nach der JP-A-2009257718 über einen Hohlboden einem Kaltgänge aufweisenden Raum zugeführt. Bei Ausfall der Klimaanlage werden in Öffnungen des Bodens angeordnete Ventilatoren in Betrieb genommen, um den Kaltgängen Luft zuzuführen.

Eine gattungsgemäße Klimaanlage ist der DE 20 2009 013 664 U1 zu entnehmen. Dabei wird aus von in Reihen angeordneten wärmeerzeugenden Geräten begrenzten Warmgängen Luft angesaugt, die über einen Hohlboden einem von einem Wärmetauscher begrenzten Raum zugeführt wird. Über den Wärmetauscher wird gekühlte Luft dem Raum zugeführt, der gegenüber den Warmgängen derart abgeschirmt ist, dass gekühlte Luft ausschließlich durch die in Reihen angeordneten wärmeerzeugenden Geräte zu einer Ventilatoreinrichtung strömen kann, die unterhalb des Wanngangs im Hohlboden angeordnet ist.

Der vorliegenden Erfindung liegt die Aufgabe zugrunde, eine Klimaanlage und ein Verfahren zum Klimatisieren eines Raums der eingangs genannten Art so weiterzubilden, dass im erforderlichen Umfang ein Kühlen der Kaltgänge auch dann erfolgen kann, wenn die Wärmelasten von Gängen unterschiedlich sind. Ferner soll der in den ersten und zweiten Raum unterteilte Gesamtraum in Bezug auf den ersten Raum flächenmäßig optimiert werden. Auch soll eine energetisch günstige Betriebsweise möglich sein.

Zur Lösung der Aufgabe sieht die Erfindung im Wesentlichen vor, dass die Wärmegänge Bereiche des ersten Raums sind, dass die Kaltgänge kopfseitig mit Abdeckungen verschlossen sind, dass jedem Kaltgang zumindest eine unmittelbar unterhalb des Kaltgangs in dem Hohlboden des Doppelbodens angeordnete Ventilatoreinrichtung zugordnet ist, dass die zumindest eine Ventilatoreinrichtung in Abhängigkeit von der Wärmelast der den Kaltgang begrenzenden wärmeerzeugenden Geräte regelbar ist, und dass unabhängig von Wärmelasten der die Kaltgänge begrenzenden wärmeerzeugenden Geräte der zweite Raum mit Zuluft konstanter Temperatur beaufschlagt wird und somit Temperatur an der Saugseite jeder Ventilatoreinrichtung gleich ist.

Abweichend vom vorbekannten Stand der Technik wird jeder Kaltgang individuell in Abhängigkeit von der Wärmelast geregelt, so dass auch bei Doppelböden mit geringem Querschnitt sichergestellt ist, dass jeder Kaltgang im erforderlichen Umfang mit der gekühlten Luft beaufschlagt wird.

Da die Ventilatoreinrichtung druckseitig über die Durchbrechungen im Doppelboden unmittelbar mit dem zugeordneten Kaltgang verbunden sind, sind dem Grunde nach aufwendige Dichtungsmaßnahmen zwischen dem ersten Raum und dem Doppelboden nicht erforderlich, wie dies nach dem Stand der Technik notwendig ist, bei dem sich die Ventilatoreinrichtung im zweiten Raum oder unmittelbar unterhalb von diesem befindet. Die Druckverhältnisse im Hohlraum sind aufgrund der erfindungsgemäßen Lehre nicht ausschlaggebend für die Kühlung der Kaltgänge, da diese unmittelbar mit der aus der Ventilatoreinrichtung austretenden gekühlten Luft beaufschlagt werden.

Verfahrensmäßig zeichnet sich die Erfindung dadurch aus, dass jedem Kaltgang zumindest eine unmittelbar unterhalb des Kaltgangs in dem Hohlraum angeordnete Ventilatoreinrichtung zugeordnet wird, dass die Ventilatoreinrichtung in Abhängigkeit von der Wärmelast der den Kaltgang begrenzenden Wärme erzeugenden Geräte geregelt wird und dass unabhängig von Wärmelast der die Kaltgänge begrenzenden Wärme erzeugenden Geräte der zweite Raum durch Regeln von den Wärmetauscher durchströmendem Kühlfluid mit Zuluft konstanter Temperatur beaufschlagt wird und somit Temperatur an der Saugseite jeder Ventilatoreinrichtung gleich ist.

Da der zweite Raum mit konstanter Temperatur beaufschlagt wird, ist die Temperatur der an der Saugseite der Ventilatoreinrichtung anzusaugenden Luft jeder Ventilatoreinrichtung gleich, so dass eine einfache Regelung möglich ist. Hierdurch ergibt sich auch eine energetisch günstige Betriebsweise.

Insbesondere ist vorgesehen, dass der zweite Raum auf eine Temperatur im Bereich zwischen 20°C und 25°C eingestellt wird.

Die Zuluft konstanter Temperatur wird dadurch sichergestellt, dass über ein Ventil die Menge des den Wärmetauscher durchströmenden Kaltwassers geregelt wird, um die durch den Wärmetauscher strömende Luft im erforderlichen Umfang zur Erzielung der gewünschten Temperatur zu kühlen.

Aufgrund der erfindungsgemäßen Lehre ergibt sich des Weiteren der Vorteil, dass der zweite Raum flächenmäßig relativ klein ausgebildet sein kann, so dass mehr Fläche für den ersten Raum zur Verfügung steht; denn die flächige Erstreckung des zweiten Raums muss dem Grunde nach nur auf einen Arbeits- oder Wartungsgang ausgelegt sein, um in dem zweiten Raum vorhandene Steuerungen und Regelungen warten zu können.

Zwar ist es bei klimatisierten Räumen bekannt, Luft über einen Doppelboden aus Warmgängen abzusaugen, die von Wärme erzeugenden Geräten begrenzt werden, die sodann über einen zumindest einen Abschnitt einer Raumwandung bildenden Wärmetauscher dem Raum als gekühlte Luft wieder zugeführt wird. Dabei kann eine individuelle Regelung der abzusaugenden Warmluft erfolgen, wie dies die DE-U-20 2009 013 664 vorsieht.

Bei der diesbezüglichen Konstruktion ist eine umfassende Abdichtung zwischen Doppelboden und dem die Wärme erzeugenden Geräte aufweisenden Raum erforderlich, da anderenfalls Warmluft in den Raum gelangen könnte, bevor diese den Wärmetauscher durchströmt. Da des Weiteren Luft aus den Warmgängen abgesaugt wird, besteht gegebenenfalls das Risiko, dass bei Arbeiten in dem Warmgang herabfallende Werkzeuge in die Ventilatoren gelangen und diese somit beschädigt werden.

Daher ist insbesondere vorgesehen, dass der zweite Raum über Durchbrechungen wie eine oder mehrere Schlitzplatten mit dem sich unterhalb des zweiten Raums erstreckenden Hohlraum des Doppelbodens verbunden ist, dass in dem zweiten Raum Steuerungen und/oder Regelungen für den Wärmetauscher und die den Kaltgängen zugeordneten Ventilatoreinrichtungen angeordnet sind, und dass flächige Erstreckung des zweiten Raums einem Arbeits- und Wartungsgang entspricht, wobei bevorzugterweise Breite B des zweiten Raums beträgt BR ≤ B ≤ 2 BR mit BR Breite des Kaltgangs.

Des Weiteren ist vorgesehen, dass die Kaltgänge parallel zueinander und parallel zu der Wandung verlaufen.

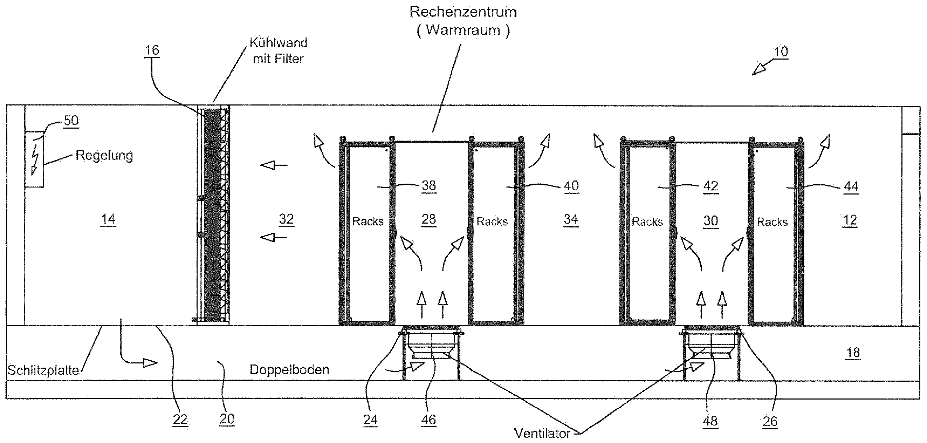

Weitere Einzelheiten, Vorteile und Merkmale der Erfindung ergeben sich nicht nur aus den Ansprüchen, den diesen zu entnehmenden Merkmalen - für sich und/oder in Kombination -, sondern auch aus der nachfolgenden Beschreibung eines der Zeichnung zu entnehmenden bevorzugten Ausführungsbeispiels.

Der einzigen Figur ist in prinzipieller Darstellung ein Querschnitt durch einen Raum 10 zu entnehmen, der in einen ersten Raum 12 und einen zweiten Raum 14 durch eine als Kühlwand 16 ausgebildete Trennwand unterteilt ist. Die Kühlwand 16 kann vollständig aus einem gehäuselosen Wärmetauscher oder abschnittsweise aus einem oder mehreren Wärmetauschern bestehen. Gehäuselos bedeutet dabei, dass ein für Klimaanlagen übliches Gehäuse nicht benötigt wird. Einzig und allein bedarf es eines Rahmens, der den oder die Wärmetauscher aufnimmt, um diese montieren zu können.

Der Raum 10, also der erste und zweite Raum 12, 14, wird bodenseitig von einem Doppelboden 18 begrenzt, der einen Hohlraum 20 einschließt, der über bodenseitig verlaufende Durchbrechungen wie Schlitzplatten 22, 24, 26 mit dem zweiten Raum 14 bzw. Kaltgängen 28, 30 in dem ersten Raum 12 verbunden ist. Die Kaltgänge 28, 30 werden von Wärme erzeugenden Geräten begrenzt, insbesondere von in Racks angeordneten Rechnern, also Anordnungen, wie diese aus Rechencentern bekannt sind. Daher handelt es sich beim dem ersten Raum 12 auch grundsätzlich um ein Rechencentrum.

Kopfseitig sind die Kaltgänge mit nicht näher gekennzeichneten Abdeckungen verschlossen, so dass die den Kaltgängen 28, 30 zugeführte gekühlte Luft die Racks durchsetzen muss. In den Bereichen der Racks, in denen Wärme erzeugende Geräte wie Server nicht angeordnet sind, werden die Racks durch Blindplatten verschlossen. Hierdurch ist sichergestellt, dass die konditionierte Luft ausschließlich die Racks in den Bereichen durchströmen kann, in denen sich Wärme erzeugende Geräte befinden.

Die den Kaltgängen 28, 30 gegenüberliegenden Seiten der Racks 38, 40, 42, 44 werden von Warmgängen bzw. Warmbereichen 32, 34, 36 begrenzt.

Vertikal unterhalb eines jeden Kaltgangs 28, 30 ist zumindest eine Ventilatoreinrichtung 46, 48 angeordnet, die mehrere Ventilatoren umfassen kann. Die Ventilatoreinrichtungen 46, 48 sind mit ihren Druckseiten unmittelbar über die Lochbleche 24, 26 mit den Kaltgängen 28, 30 strömungstechnisch verbunden. Dies wird auch durch die Pfeile symbolisiert.

Zum Klimatisieren der Kaltgänge 28, 30 wird über die Ventilatoreinrichtung 46, 48 Warmluft aus den Warmluftbereichen 32, 34, 36 über den oder die Wärmetauscher der Kühlwand 16 angesaugt, um über den zweiten Raum 12 in den Hohlboden 20 des Doppelbodens 18 zu strömen und somit über die Ventilatoreinrichtung 46, 48 in die Kaltgänge 28, 30 zu gelangen.

Da den Kaltgängen 28, 30 unmittelbar jeweils eine Ventilatoreinrichtung 46, 48 zugeordnet ist, die jeweils individuell in Abhängigkeit von der Wärmelast des jeweiligen Kaltgangs 28, 30 geregelt werden können, ist es möglich, auch Hohlräume 20 mit relativ geringen Querschnitten zu nutzen, da es nicht erforderlich ist, dass in dem Doppelboden 18 , also dem Hohlraum 20, ein statischer Druck herrscht, wie dies nach dem Stand der Technik dann erforderlich ist, wenn in dem zweiten Raum 14 oder unmittelbar unter diesem, also unterhalb der Schlitzplatte 22, eine Ventilatoreinrichtung angeordnet ist.

Durch die Anordnung der Ventilatoreinrichtung 46, 48 unmittelbar unterhalb der Kaltgänge 28, 30 ist des Weiteren der Vorteil gegeben, dass der zweite Raum 14 flächenmäßig relativ klein ausgelegt sein kann, da es nur erforderlich ist, dass innerhalb des zweiten Raums 14 hinreichend Platz gegeben ist, um Wartungs- und Montagearbeiten für die Regelung bzw. Steuerung durchzuführen. Dies spiegelt die Darstellung in der einzigen Figur allerdings nicht wider.

Die Breite B des zweiten Raums 14 kann dabei in etwa Breite BR oder der doppelten Breite eines Kaltgangs 28, 30 entsprechen.

In dem zweiten Raum 14 befindet sich zumindest ein Temperatursensor, über den ein nicht dargestelltes Ventil geregelt wird, dass die Menge des den Wärmetauscher durchströmenden Kaltwassers oder sonstigen Kühlfluids derart geregelt wird, dass in dem zweiten Raum 12 eine gewünschte konstante oder im Wesentlichen konstante Temperatur herrscht.

Erwähntermaßen kann die Kühlwand 16 insgesamt als Wärmetauscher ausgebildet sein. Die Erfindung wird jedoch nicht verlassen, wenn nur Bereiche der Kühlwand 16 Wärmetauscher aufweisen.

## Patentansprüche

1. Klimaanlage umfassend einen Wärmetauscher und zumindest eine eine Saug- und eine Druckseite aufweisende Ventilatoreinrichtung (46, 48), wobei
- der Wärmetauscher zumindest Abschnitt einer einen zu kühlenden ersten Raum (12) von einem zweiten Raum (14) begrenzenden Wandung ist,
- der zweite Raum (14) strömungstechnisch über die Ventilatoreinrichtung (46, 48) mit einem zumindest den ersten Raum, vorzugsweise sowohl den ersten als auch den zweiten Raum begrenzenden und einen Hohlraum (20) aufweisenden Doppelboden (18) verbunden ist,
- auf dem Doppelboden mehrere Kaltgänge (28, 30) verlaufen, die von wärmeerzeugenden Geräten wie in Racks (38, 40, 42, 44) angeordneten Rechnern begrenzt sind,
- die Kaltgänge werden von Warmgängen (32, 34, 36) begrenzt, und
- die Kaltgänge über Durchbrechungen, wie Schlitzplatten (24, 26), mit dem Hohlraum zum Zuführen von klimatisierter Luft in die Kaltgänge verbunden sind,
**dadurch gekennzeichnet,**
**dass** die Warmgänge (32, 34, 36) Bereiche des ersten Raums (R) sind, dass die Kaltgänge (28, 30) kopfseitig mit Abdeckungen verschlossen sind, dass jedem Kaltgang (28, 30) zumindest eine unmittelbar unterhalb des Kaltgangs in dem Hohlboden (20) des Doppelbodens (18) angeordnete Ventilatoreinrichtung (46, 48) zugordnet ist,
**dass** die zumindest eine Ventilatoreinrichtung in Abhängigkeit von der Wärmelast der den Kaltgang begrenzenden wärmeerzeugenden Geräte regelbar ist, und
**dass** unabhängig von Wärmelasten der die Kaltgänge (28, 30) begrenzenden wärmeerzeugenden Geräte der zweite Raum (14) mit Zuluft konstanter Temperatur beaufschlagt wird und somit Temperatur an der Saugseite jeder Ventilatoreinrichtung gleich ist.

2. Klimaanlage nach Anspruch 1,
**dadurch gekennzeichnet,**
**dass** der zweite Raum (14) über Durchbrechungen, wie eine oder mehrere Schlitzplatten (22), mit dem sich unterhalb des zweiten Raums (14) erstreckenden Hohlraum (20) des Doppelbodens (18) verbunden ist,
**dass** in dem zweiten Raum Steuerungen und/oder Regelungen (50) für den Wärmetauscher und die den Kaltgängen (28, 30) zugeordneten Ventilatoreinrichtungen (46, 48) angeordnet sind, und
**dass** flächige Erstreckung des zweiten Raums einem Arbeits- und Wartungsgang entspricht.

3. Klimaanlage nach Anspruch 2,
**dadurch gekennzeichnet,**
**dass** Breite B des zweiten Raums (14) beträgt BR ≤ B ≤ 2 BR mit BR Breite des Kaltgangs (28, 30).

4. Klimaanlage nach zumindest Anspruch 1,
**dadurch gekennzeichnet,**
**dass** jede der einem der Kaltgänge (28, 30) zugeordneten Ventilatoreinrichtungen (46, 48) mit ihrer Druckseite ausschließlich über die Durchbrechungen, wie den Schlitzplatten (24, 26), mit dem Kaltgang (28, 30) verbunden ist.

5. Klimaanlage nach zumindest einem der vorherigen Ansprüche.
**dadurch gekennzeichnet,**
**dass** zumindest einem Kaltgang (28, 30), insbesondere jedem Kaltgang, zumindest zwei Ventilatoreinrichtungen (46, 48) zugeordnet sind, die vorzugsweise als Einheit regelbar sind.

6. Klimaanlage nach zumindest einem der vorherigen Ansprüche.
**dadurch gekennzeichnet,**
**dass** die Kaltgänge (28, 30) parallel zueinander und parallel zu der Wandung (16) verlaufen, von der zumindest ein Abschnitt der Wärmetauscher ist.

7. Verfahren zum Betreiben einer Klimaanlage gemäß Anspruch 1, zum Klimatisieren eines von wärmeerzeugenden Geräten begrenzte Kaltgänge (28, 30) aufweisenden ersten Raums (12), der von einer zumindest abschnittsweise als Wärmetauscher ausgebildeten Wandung begrenzt ist, die einen zweiten Raum (14) begrenzt, der strömungstechnisch über zumindest eine Ventilatoreinrichtung (46, 48) über einen zumindest den ersten Raum bodenseitig begrenzenden Durchbrechungen aufweisenden Hohlraum (18) mit den Kaltgängen verbunden wird, wobei mittels der zumindest einen Ventilatoreinrichtung Luft von dem ersten Raum über den Wärmetauscher strömend den Kaltgängen zugeführt wird,
**dadurch gekennzeichnet,**
**dass** jedem Kaltgang (28, 30) zumindest eine unmittelbar unterhalb des Kaltgangs in dem Hohlraum (18) angeordnete Ventilatoreinrichtung (46, 48) zugeordnet wird, dass die Ventilatoreinrichtung in Abhängigkeit von der Wärmelast der den Kaltgang begrenzenden wärmeerzeugenden Geräte geregelt wird und dass unabhängig von Wärmelast der die Kaltgänge begrenzenden wärmeerzeugenden Geräte der zweite Raum durch Regeln von den Wärmetauscher durchströmendem Kühlfluid mit Zuluft konstanter Temperatur beaufschlagt wird und somit Temperatur an der Saugseite jeder Ventilatoreinrichtung gleich ist.

8. Verfahren nach Anspruch 7,
**dadurch gekennzeichnet,**
**dass** zumindest einem der Kaltgänge (28, 30), vorzugsweise jedem Kaltgang, zumindest zwei Ventilatoreinrichtungen (46, 48) zugeordnet werden, die vorzugsweise als Einheit geregelt werden.

## Claims

1. Air-conditioning system comprising a heat exchanger and at least one fan system (46, 48) having an intake side and a discharge side, where
- the heat exchanger is at least a section of a wall limiting a first room (12) to be cooled from a second room (14),
- the second room (14) is flow-connected via the fan system (46, 48) to a double floor (18) limiting at least the first room, preferably both the first and the second room, and having a cavity (20),
- a plurality of cold aisles (28, 30) extends on the double floor and are limited by heat-generating units such as computers arranged in racks (38, 40, 42, 44),
- the cold aisles are limited by hot aisles (32, 34, 36), and
- the cold aisles are connected via through-holes such as slotted panels (24, 26) to the cavity for supplying air-conditioned air into the cold aisles,
wherein
the hot aisles (32, 34, 36) are areas of the first room (R), the cold aisles (28, 30) are closed at the top with covers, at least one fan system (46, 48) arranged in the hollow floor (20) of the double floor (18) directly underneath the cold aisle is associated with each cold aisle (28, 30),
the at least one fan system is controllable depending on the thermal load of the heat-generating units limiting the cold aisle, and regardless of the thermal loads of the heat-generating units limiting the cold aisles (28, 30) supply air of a constant temperature is applied to the second room (14), and hence the temperature at the intake side of each fan system is identical.

2. Air-conditioning system according to claim 1,
wherein
the second room (14) is connected to the cavity (20) of the double floor (18) extending underneath the second room (14) via through-holes such as one or more slotted panels (22),
open-loop and/or closed-loop controls (50) for the heat exchanger and the fan systems (46, 48) associated with the cold aisles (28, 30) are arranged in the second room, and the extent of the second room area corresponds to a work and maintenance aisle.

3. Air-conditioning system according to claim 2,
wherein
width B of the second room (14) is BR ≤ B ≤ 2 BR, with BR being the width of the cold aisle (28, 30).

4. Air-conditioning system according to at least claim 1,
wherein
each of the fan systems (46, 48) associated with one of the cold aisles (28, 30) is connected on its discharge side to the cold aisle (28, 30) exclusively via the through-holes such as slotted panels (24, 26).

5. Air-conditioning system according to at least one of the preceding claims,
wherein
at least two fan systems (46, 48) are associated with at least one cold aisle (28, 30), in particular each cold aisle, and are preferably controllable as a unit.

6. Air-conditioning system according to at least one of the preceding claims,
wherein
the cold aisles (28, 30) are parallel to one another and parallel to the wall (16), at least one section of which is the heat exchanger.

7. Method for operating an air-conditioning system according to claim 1, for air-conditioning a first room (12) having cold aisles (28, 30) limited by heat-generating units, and limited by a wall designed at least in some sections as a heat exchanger and limiting a second room (14) which is flow-connected to the cold aisles by at least one fan system (46, 48) via a cavity (18) having through-holes and limiting at least the first room at the bottom, where air is supplied from the first room to the cold aisles by means of the at least one fan system by flowing through the heat exchanger,
wherein
at least one fan system (46, 48) arranged in the cavity (18) directly underneath the cold aisle is associated with each cold aisle (28, 30), the fan system is controlled depending on the thermal load of the heat-generating units limiting the cold aisle, and regardless of the thermal load of the heat-generating units limiting the cold aisles supply air of a constant temperature is applied to the second by control of the cooling liquid flowing through the heat exchanger, and hence the temperature at the intake side of each fan system is identical.

8. Method according to claim 7,
wherein
at least two fan systems (46, 48) are associated with at least one of the cold aisles (28, 30), in particular each cold aisle, and are preferably controllable as a unit.

## Revendications

1. Climatisation comprenant un échangeur thermique et au moins un dispositif de ventilation (46, 48) présentant un côté aspiration et un côté refoulement, sachant que
- l'échangeur thermique constitue au moins une section d'une paroi séparant une première pièce à refroidir (12) d'une seconde pièce (14),
- la seconde pièce (14) est reliée fluidiquement à un double plancher (18) délimitant au moins la première pièce, de préférence délimitant aussi bien la première que la seconde pièce et présentant un espace creux (20), par le biais du dispositif de ventilation (46, 48).
- s'étendent sur le double plancher plusieurs corridors froids (28, 30) qui sont délimités par des appareils produisant de la chaleur tels que des ordinateurs disposés dans des baies (38, 40, 42, 44),
- les corridors froids sont délimités par des corridors chauds (33, 34, 36), et
- les corridors froids sont reliés à l'espace creux par des percées, telles que des plaques perforées (24, 26), pour alimenter les corridors froids en air climatisé,
**caractérisée en ce**
**que** les corridors chauds (32, 34, 36) sont des zones de la première pièce (R), que les corridors froids (28, 30) sont fermés côté frontalpar des caches, qu'au moins un dispositif de ventilation (46, 48) disposé juste sous le corridor froid dans l'espace creux (20) du double plancher (18) est attribué à chaque corridor froid (28, 30), que ledit au moins un dispositif de ventilation est régulable en fonction de la charge thermique des appareils produisant de la chaleur, délimitant le corridor froid et qu'indépendamment des charges thermiques des appareils produisant de la chaleur, délimitant les corridors froids (28, 30), la seconde pièce (14) est alimentée en air à température constante et que la température est ainsi identique sur le côté aspiration de chaque dispositif de ventilation.

2. Climatisation selon la revendication 1,
**caractérisée en ce**
**que** la seconde pièce (14) est reliée à l'espace creux (20) du double plancher (18), s'étendant sous la seconde pièce (14), par l'intermédiaire de percées telles qu'une ou plusieurs plaques à fentes (22),
**que** des contrôles ouverts et/ou fermés (50) pour l'échangeur thermique et les dispositifs de ventilation (46, 48) attribués aux corridors froids (28, 30) sont disposés dans la seconde pièce, et
**que** la surface de la seconde pièce correspond à un corridor de travail ou de maintenance.

3. Climatisation selon la revendication 2,
**caractérisée en ce**
**que** la largeur B de la seconde pièce (14) est telle que BR ≤ B ≤ 2 BR, BR étant la largeur du corridor froid (28, 30).

4. Climatisation selon au moins la revendication 1,
**caractérisée en ce**
**que** chacun des dispositifs de ventilation (46, 48) attribués à un des corridors froids (28, 30) est relié au corridor froid (28, 30) au niveau de son côté refoulement exclusivement par l'intermédiaire des percées telles que lesdites plaques à fentes (24, 26).

5. Climatisation selon au moins une des revendications précédentes,
**caractérisée en ce**
**qu'**au moins deux dispositifs de ventilation (46, 48) qui sont régulables de préférence comme unité sont attribués à au moins un corridor froid (28, 30), notamment à chaque corridor froid.

6. Climatisation selon au moins une des revendications précédentes,
**caractérisée en ce**
**que** les corridors froids (28, 30) sont parallèles les uns par rapport aux autres et parallèles à la paroi (16) dont au moins une section est constituée par l'échangeur thermique.

7. Procédé d'exploitation d'une climatisation selon la revendication 1, destiné à climatiser une première pièce (12) présentant des corridors froids (28, 30) délimités par des appareils produisant de la chaleur, laquelle première pièce est délimitée par une paroi conçue au moins partiellement sous la forme d'un échangeur thermique et délimitant une seconde pièce (14) qui est reliée fluidiquement aux corridors froids par le biais d'au moins un dispositif de ventilation (46, 48), par le biais d'au moins un espace creux (18) présentant des percées délimitant côté sol la première pièce, sachant qu'au moyen dudit au moins un dispositif de ventilation, de l'air provenant de la première pièce est distribué par flux aux corridors froids par le biais de l'échangeur thermique,
**caractérisé en ce**
**qu'**au moins un dispositif de ventilation (46, 48) disposé juste sous le corridor froid, dans l'espace creux (18) est attribué à chaque corridor froid (28, 30), que le dispositif de ventilation est régulé en fonction de la charge thermique des appareils produisant de la chaleur, délimitant le corridor froid et qu'indépendamment de la charge thermique des appareils produisant de la chaleur et délimitant les corridors froids, la seconde pièce est alimentée en air à température constante par la régulation du fluide de refroidissement traversant l'échangeur thermique et qu'ainsi, la température est identique sur le côté aspiration de chaque dispositif de ventilation.

8. Procédé selon la revendication 7,
**caractérisé en ce**
**qu'**au moins deux dispositifs de ventilation (46, 48) qui sont régulables de préférence comme unité sont attribués à au moins un des corridors froids (28, 30), de préférence à chaque corridor froid.
